# EUROPEAN PATENT APPLICATION

(11) **EP 3 815 815 A1**
(43) Date of publication of application: **05.05.2021**
(21) Application number: 20199557.8
(22) Date of filing: 01.10.2020
(51) Int. Cl.: B22F 1/00, B22F 3/11, F28D 15/04, H01L 23/427, H05K 7/20

(54) **VAPOR CHAMBER AND CAPILLARY FILM THEREOF**

(30) Priority: 31.10.2019 TW 108139438
(71) Applicant: Sunonwealth Electric Machine Industry Co., Ltd., Kaohsiung City / Taiwan, R.O.C. (TW)
(72) Inventor: Horng, Alex, Kaohsiung City, Taiwan (R.O.C.) (TW); Li, Ming-Tsung, Kaohsiung City, Taiwan (R.O.C.) (TW)
(74) Representative: Louis Pöhlau Lohrentz

(57) **Abstract**

A vapor chamber includes a casing (1), a working liquid, and a capillary film (2). The casing (1) includes a heat-absorbing sheet (1a) and a heat-releasing sheet (1b) opposite to the heat-absorbing sheet (1a). The casing (1) includes a sealed space (S) therein. The working liquid is filled in the sealed space (S). The capillary film (2) is received in the sealed space (S) and contacts the working liquid. The capillary film (2) is produced from sintering a mixture including thermally conductive particles of at least two different lengths.

## Description

### BACKGROUND OF THE INVENTION

### 1. Field of the Invention

The present invention relates to an article for assisting in cooling electronic products and, more particularly, to a vapor chamber and a capillary film thereof.

### 2. Description of the Related Art

With progress of the technology industries, current electronic products, such as notebooks or mobile phones, not only provide excellent performances but also have a development trend of miniaturization and thinning. However, the miniature and thin high-performance electronic products tend to produce a considerable amount of waste heat during operation, leading to an increase in the temperature of the electronic products, thereby resulting in an increase of the failure rate and the loss rate of the electronic products.

Thus, it is known to install a vapor chamber to the heat source of an electronic product to discharge the waste heat generated during operation of the electronic product. Specifically, the conventional vapor chamber includes a metal casing formed by punching. A capillary structure is disposed in the metal casing and is filled with a working fluid. The metal casing can absorb heat energy from the heat source to heat and vaporize the working fluid. The gaseous working fluid continues to flow to a side of the metal casing remote to the heat source and then condenses into a liquid state. In this way, the working fluid can carry away the heat energy of the heat source to thereby achieve the cooling purposes.

The capillary structure is generally formed by sintering metal particles having substantially identical diameters. Namely, given the capillary structure with a sufficient thickness, the capillary structure has an sufficient strength and, thus, will not break during assembly. However, due to the development demand in further thinning, the thickness of the vapor chamber must be further reduced, which could lead to easy breakage of the capillary structure due to insufficient strength. In light of this, it is necessary to improve the conventional thin film transistor and its manufacturing method.

### SUMMARY OF THE INVENTION

To solve the above disadvantages, it is an objective of the present invention to provide a vapor chamber and a capillary film thereof, such that the capillary film still has an excellent strength to avoid breakage even though the thickness is reduced.

It is another objective of the present invention to provide a vapor chamber and a capillary film thereof, enhancing the thermal conduction effect of the capillary film.

It is a further objective of the present invention to provide a vapor chamber and a capillary film thereof, increasing the overall cooling efficiency of the vapor chamber.

It is yet another objective of the present invention to provide a vapor chamber to increase the assembling efficiency.

When the terms "front", "rear", "left", "right", "up", "down", "top", "bottom", "inner", "outer", "side", and similar terms are used herein, it should be understood that these terms have reference only to the structure shown in the drawings as it would appear to a person viewing the drawings and are utilized only to facilitate describing the invention, rather than restricting the invention.

As used herein, the term "a" or "an" for describing the number of the elements and members of the present invention is used for convenience, provides the general meaning of the scope of the present invention, and should be interpreted to include one or at least one. Furthermore, unless explicitly indicated otherwise, the concept of a single component also includes the case of plural components.

As used herein, the term "coupling", "engagement", "assembly", or similar terms is used to include separation of connected members without destroying the members after connection or inseparable connection of the members after connection. A person having ordinary skill in the art would be able to select according to desired demands in the material or assembly of the members to be connected.

A capillary film according to the present invention is produced from sintering a mixture including thermally conductive particles of at least two different lengths.

A vapor chamber according to the present invention comprises a casing, a working liquid, and the above-mentioned capillary film. The casing includes a heat-absorbing sheet and a heat-releasing sheet opposite to the heat-absorbing sheet. The casing includes a sealed space therein. The working liquid is filled in the sealed space. The capillary film is received in the sealed space and contacts the working liquid.

Accordingly, in the vapor chamber and its capillary film according to the present invention, thermally conductive particles having at least two different lengths are sintered to form the capillary film, such that relatively longer thermally conductive particles can link with each other like fibers after sintering to thereby increase the bonding strength between the thermally conductive particles. Thus, even though the thickness of the capillary film is extremely small, the capillary film can still have an excellent structural strength and is, thus, less likely to break, which is advantageous to development of thinning of the vapor chamber.

In an example, the thermally conductive particles include longest thermally conductive particles and shortest thermally conductive particles. The longest thermally conductive particles have a length about 5-25 times, preferably 10-20 times, of a length of the shortest thermally conductive particles. Thus, the bonding strength between the thermally conductive particles is increased.

In an example, the mixture includes the thermally conductive particles having at least one material selected from copper, copper alloy, aluminum, and aluminum alloy. Thus, the thermal conduction effect of the capillary film is increased.

In an example, the mixture includes the thermally conductive particles having metal particles and graphite particles. Thus, the thermal conduction effect of the capillary film is increased.

In an example, the thermally conductive particles include different materials. Thus, thermally conductive particles of different costs can be selected according to need to thereby reduce the cost of the capillary film.

In an example, the capillary film has a thickness of 0.05-0.5 mm, preferably 0.2-0.4 mm. Thus, the thickness of the capillary film is reduced.

In an example, the capillary film includes a first layer and a second layer disposed on a top of the first layer. Each of the first layer and the second layer is comprised of the thermally conductive particles of at least two different lengths. The density of the first layer is larger than the density of the second layer. Accordingly, the cooling efficiency of the whole vapor chamber is further increased.

In an example, the casing includes at least one supporting post located in the sealed space. The capillary film has at least one through-hole. The at least one supporting post extends through the at least one through-hole. The at least one supporting post has two ends connected to the heat-absorbing sheet and the heat-releasing sheet, respectively. Thus, the deformation of the casing can be reduced to increase the structural strength and reliability of the casing.

In an example, the at least one supporting post is integrally formed with or coupled to the heat-releasing sheet. At least one positioning stub is integrally formed with or coupled to the heat-absorbing sheet and has a recess. The at least one positioning stub is received in the at least one through-hole of the capillary film. The at least one supporting post extends into the recess of the at least one positioning stub. Thus, the heat-absorbing sheet and the heat-releasing sheet can be accurately aligned during coupling, increasing the assembling efficiency.

In an example, the at least one positioning stub has a non-circular outer periphery. This avoids the capillary film from rotating relative to the casing during assembly, increasing the assembling efficiency and accuracy.

In an example, each of the heat-absorbing sheet and the heat-releasing sheet includes a sink formed by etching. Each sink has an annular wall disposed therearound. The annular wall of the heat-absorbing sheet and the annular wall of the heat-releasing sheet contact each other. The two annular walls are coupled by laser welding around contacted portions thereof. Thus, the thickness of the casing is reduced, and the coupling reliability is increased.

The present invention will become clearer in light of the following detailed description of illustrative embodiments of this invention described in connection with the drawings.

### BRIEF DESCRIPTION OF THE DRAWINGS

FIG. 1 is an exploded, perspective view of a vapor chamber of an embodiment according to the present invention.
FIG. 2 is a partial, cross sectional view of the vapor chamber of the embodiment according to the present invention.
FIG. 3 is a perspective view of a capillary film of the vapor chamber of the embodiment according to the present invention.
FIG. 4 is a cross sectional view of a capillary film of another embodiment according to the present invention.

### DETAILED DESCRIPTION OF THE INVENTION

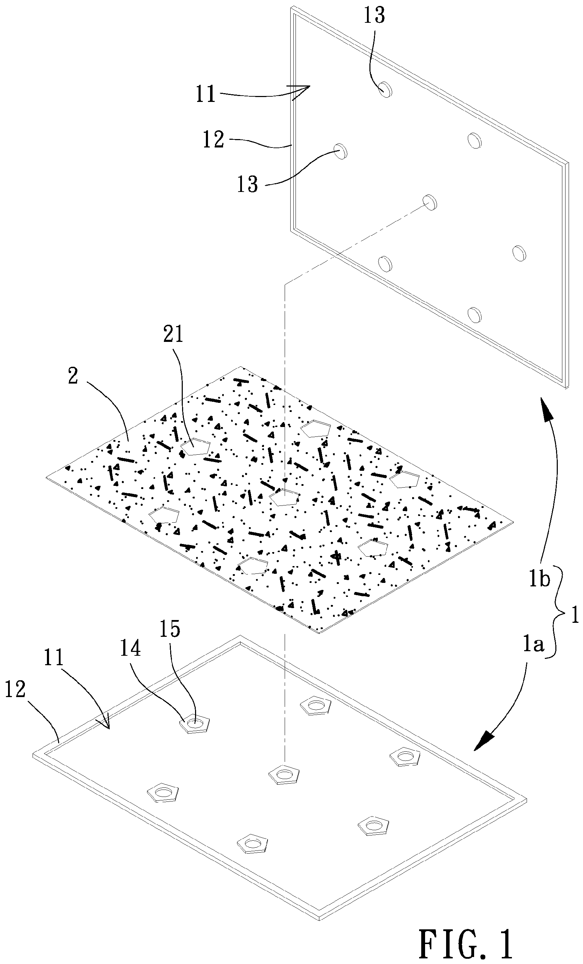

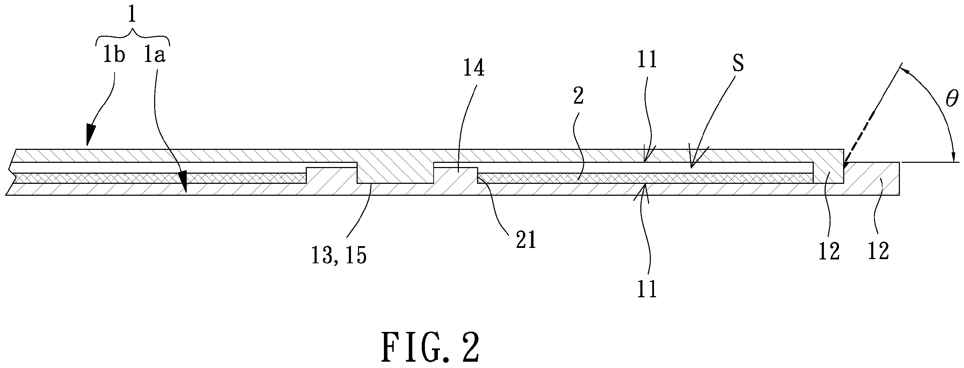

With reference to FIGs. 1 and 2, a vapor chamber of an embodiment according to the present invention includes a casing 1 and a capillary film 2. The capillary film 2 is received in the casing 1.

The casing 1 includes a heat-absorbing sheet 1a and a heat-releasing sheet 1b opposite to the heat-absorbing sheet 1a. The casing 1 includes a sealed space S therein. The sealed space S is filled with a working liquid (not shown) and receives the capillary film 2. The sealed space S is preferably in a vacuum state. The working liquid can be pure water, ethanol, etc. The working liquid will not fill the whole sealed space S when in a liquid state.

Specifically, the heat-absorbing sheet 1a and the heat-releasing sheet 1b can be made of copper, aluminum, or other material having a high coefficient of thermal conduction. At least one of the heat-absorbing sheet 1a and the heat-releasing sheet 1b may have a sink 11, such that the above-mentioned sealed space **S** is formed between the heat-absorbing sheet 1a and the heat-releasing sheet 1b after coupling. For example, but not limited hereto, an etching process may be adopted in this embodiment to form a sink 11 in each of two mutually facing faces of the heat-absorbing sheet 1a and the heat-releasing sheet 1b. Furthermore, each sink 11 has an annular wall 12 disposed therearound, such that the heat-releasing sheet 1b can be placed into the sink 11 of the heat-absorbing sheet 1a. Furthermore, the two annular walls 12 can be coupled by laser welding around contacted portions thereof to form the sealed space **S** from the sink 11 of the heat-releasing sheet 1a. The angle θ of proceeding the laser welding is preferably 30° -75° to the horizontal plane, increasing the operational convenience of laser welding. In another embodiment, a reverse arrangement can be made. Namely, the heat-absorbing sheet 1a is placed into the sink 11 of the heat-releasing sheet 1b, and the sealed space **S** is formed from the sink 11 of the heat-receiving sheet 1a. Alternatively, the annular wall 12 of the heat-absorbing sheet 1a and the annular wall 12 of the heat-releasing sheet 1b are superimposed to form the sealed space **S** from both sinks 11. Other equivalent structures can also be provided. Thus, the casing 1 is not limited to the structure illustrated in the figures of this embodiment.

Furthermore, the casing 1 can include at least one supporting post 13 located in the sealed space **S.** The at least one supporting post 13 has two ends connected to the heat-absorbing sheet 1a and the heat-releasing sheet 1b, respectively. The at least one supporting post 13 can support portions of the heat-absorbing sheet 1a and the heat-releasing sheet 1b within the annular walls 12 to reduce the deformation of the casing 1. In this embodiment, the at least one supporting post 13 can be integrally formed with or coupled to the heat-releasing sheet 1b. The casing 1 can further include at least one positioning stub 14. The at least one positioning stub 14 can be integrally formed with or coupled to the heat-absorbing sheet 1a and has a recess 15 through which the at least one supporting post 13 extends to couple. Preferably, the at least one positioning stub 14 can have a non-circular outer periphery.

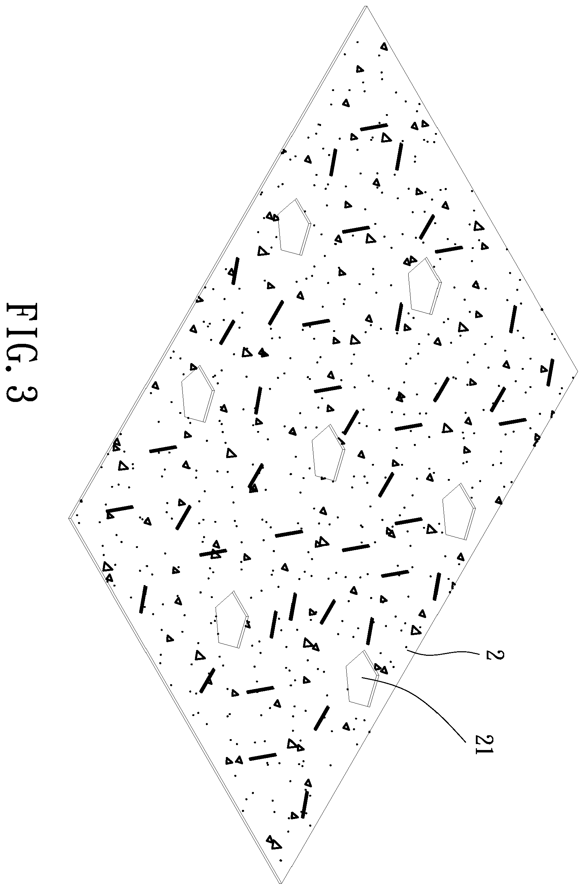

With reference to FIGs. 2 and 3, the capillary film 2 is received in the sealed space **S** and contacts the working liquid. The capillary film 2 is a porous sheet produced from sintering a mixture. The capillary film 2 is relatively thin and has a thickness of about only 0.05-0.5 mm, preferably 0.2-0.4 mm. For example, powder metallurgy, such as sintering, can be carried out on the mixture, and the sintered powders can undergo pressing, flattening, etc. to obtain the capillary film 2 of the desired thickness, shape, or proper size. Furthermore, during the pressing and flattening procedures, grooves can be formed on the capillary film 2 at the same time to increase the flow guiding capability of the capillary film 2.

The mixture includes thermally conductive particles of at least two different lengths. In the present invention, "thermally conductive particles of a certain length" means a group of thermally conductive particles and, among which, each thermally conductive particle has a length close to an average length of the group of thermally conductive particles, ignoring manufacturing tolerance. Thus, the porous film formed by sintering has a better structural strength and is less likely to break. For example, a length of the longest thermally conductive particles is about 5-25 (preferably about 10-20) times of a length of the shortest thermally conductive particles.
After sintering, relatively longer thermally conductive particles can link with each other like fibers to increase the bonding strength between the thermally conductive particles. Furthermore, the shortest thermally conductive particles can be approximately ball-shaped and can have a diameter of about 1-25 µm. The shapes of the thermally conductive particles of different lengths can be identical or different. The present invention is not limited in this regard. The shape for a thermally conductive particle is defined by the cross-sectional shape perpendicular to a long axis of the thermally conductive particle.

The mixture can mainly include thermally conductive particles having at least one material selected from copper, copper alloy, aluminum, and aluminum alloy. Thus, the capillary film 2 can have an excellent thermally conductive effect. Namely, the longest thermally conductive particles and the shortest thermally conductive particles can be an identical material or different materials. The present invention is not limited in this regard. For example, in a case that the cooling demand is not too high, thermally conductive particles with lower costs can be mixed to effectively reduce the material cost of the capillary film 2. Furthermore, the mixture does not have to be totally comprised of thermally conductive particles being metal but can also include non-metal thermally conductive particles, such as thermally conductive particles being graphite. Namely, the thermally conductive particles can have both graphite particles and metal particles, which include at least one material selected from copper, copper alloy, aluminum, and aluminum alloy, thereby increasing the thermal conduction effect of the capillary film 2 produced from sintering.

In the embodiment in which the casing 1 includes at least one supporting post 13 and at least one positioning stub 14, the capillary film 2 can have at least one through-hole 21. The at least one positioning stub 14 is fitted in the at least one through-hole 21 of the capillary film 2 to prevent rotation of the capillary film 2 relative to the heat-absorbing sheet 1a. Then, the heat-absorbing sheet 1a is coupled to the heat-releasing sheet 1b with the at least one supporting post 13 extending into the recess 15 of the at least one positioning stub 14. Thus, the heat-absorbing sheet 1a and the heat-releasing sheet 1b can be accurately aligned. Next, spot welding is carried out to weld the at least one supporting post 13 to the heat-absorbing sheet 1a.

With reference to FIGs. 1 and 2 again, the vapor chamber according to the present invention can be effectively thinned through the above structure. Furthermore, when using the vapor chamber, the heat-absorbing sheet 1a of the casing 1 can contact the heat source to absorb the heat energy. The heat energy heats the working liquid in the sealed space **S,** such that the working liquid can absorb the heat energy and vaporize into gaseous state. The vaporized working liquid condenses into the liquid state when contacting with the heat-releasing sheet 1b of a relatively lower temperature. Thus, the working liquid can continuously proceed with the cycle of phase change between the liquid state and the gaseous state by the capillary phenomenon of the capillary film 2 to carry away the heat energy of the heat source, thereby achieving effective cooling effect for the heat source.

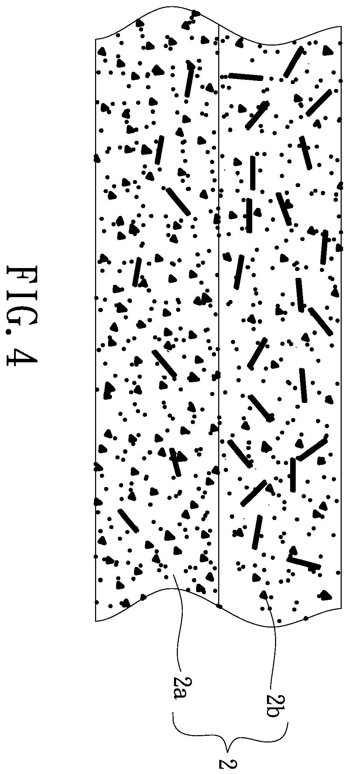

With reference to FIG. 4, it is worth noting that the capillary film 2 can include a first layer 2a and a second layer 2b disposed on top of the first layer 2a, such that the first layer 2a is more adjacent to the heat-absorbing sheet 1a than the second layer 2b. Each of the first layer 2a and the second layer 2b is comprised of the thermally conductive particles of at least two different lengths. The first layer 2a and the second layer 2b can have different densities. Preferably, the density of the first layer 2a is larger than the density of the second layer 2b. In a non-limiting example, the number of the relatively shorter thermally conductive particles in the first layer 2a can be larger than the number of the relatively longer thermally conductive particles in the first layer 2a, and the number of the relatively longer thermally conductive particles in the second layer 2b can be larger than the number of the relatively shorter thermally conductive particles in the second layer 2b, such that the density of the first layer 2a can be larger than the density of the second layer 2b. Thus, the first layer 2a can provide a better capillary function for the working liquid, assisting in upward flow and vaporization of the working liquid. The second layer 2b can have more pores to increase the flowing capability of the vaporized working liquid, which is helpful in smooth condensation into the liquid state, thereby further increasing the cooling efficiency of the vapor chamber in a whole.

In view of the forgoing, in the vapor chamber and its capillary film according to the present invention, thermally conductive particles of at least two different lengths are sintered to form the capillary film 2, such that the relatively longer thermally conductive particles can link with each other like fibers after sintering to thereby increase the bonding strength between the thermally conductive particles. Thus, even though the thickness of the capillary film 2 is reduced to an extreme size smaller than 0.5 mm, the capillary film 2 can still have an excellent structural strength and is, thus, less likely to break, which is advantageous to development of thinning of the vapor chamber.

Although the invention has been described in detail with reference to its presently preferable embodiments, it will be understood by one of ordinary skill in the art that various modifications can be made without departing from the scope of the invention, as set forth in the appended claims.

## Claims

1. A capillary film (2) **characterized in** produced from sintering a mixture including thermally conductive particles of at least two different lengths.

2. The capillary film (2) as claimed in claim 1, **characterized in that** the thermally conductive particles include longest thermally conductive particles and shortest thermally conductive particles, and wherein the longest thermally conductive particles have a length 5-25 times of a length of the shortest thermally conductive particles.

3. The capillary film (2) as claimed in claim 1, **characterized in that** the thermally conductive particles include longest thermally conductive particles and shortest thermally conductive particles, and wherein the longest thermally conductive particles have a length 10-20 times of a length of the shortest thermally conductive particles.

4. The capillary film (2) as claimed in one of claims 1-3, **characterized in that** the mixture includes the thermally conductive particles having at least one material selected from copper, copper alloy, aluminum, and aluminum alloy.

5. The capillary film (2) as claimed in one of claims 1-4, **characterized in that** the mixture includes the thermally conductive particles having metal particles and graphite particles.

6. The capillary film (2) as claimed in one of claims 1-5, **characterized in that** the thermally conductive particles include different materials.

7. The capillary film (2) as claimed in one of claims 1-6, **characterized in that** the capillary film (2) has a thickness of 0.05-0.5 mm.

8. The capillary film (2) as claimed in claim 7, **characterized in that** the capillary film (2) has a thickness of 0.2-0.4 mm.

9. The capillary film (2) as claimed in one of claims 1-8, **characterized in that** the capillary film includes a first layer (2a) and a second layer (2b) disposed on a top of the first layer (2a), wherein each of the first layer (2a) and the second layer (2b) is comprised of the thermally conductive particles of at least two different lengths, and wherein a density of the first layer (2a) is larger than a density of the second layer (2b).

10. A vapor chamber **characterized in** comprising:
a casing (1) including a heat-absorbing sheet (1a) and a heat-releasing sheet (1b) opposite to the heat-absorbing sheet (1a), wherein the casing (1) includes a sealed space (**S**) therein;
a working liquid filled in the sealed space (**S**); and
a capillary film (2) set forth in claim 1, wherein the capillary film (2) is received in the sealed space (**S**) and contacts the working liquid.

11. The vapor chamber as claimed in claim 10, **characterized in that** the casing (1) includes at least one supporting post (13) located in the sealed space (**S**), wherein the capillary film (2) has at least one through-hole (21), wherein the at least one supporting post (13) extends through the at least one through-hole (21), and wherein the at least one supporting post (13) has two ends connected to the heat-absorbing sheet (1a) and the heat-releasing sheet (1b), respectively.

12. The vapor chamber as claimed in claim 11, **characterized in that** the at least one supporting post (13) is integrally formed with or coupled to the heat-releasing sheet (1b), wherein at least one positioning stub (14) is integrally formed with or coupled to the heat-absorbing sheet (1a) and has a recess (15), wherein the at least one positioning stub (14) is received in the at least one through-hole (21) of the capillary film (2), and wherein the at least one supporting post (13) extends into the recess (15) of the at least one positioning stub (14).

13. The vapor chamber as claimed in claim 12, **characterized in that** the at least one positioning stub (14) has a non-circular outer periphery.

14. The vapor chamber as claimed in one of claims 10-13, **characterized in that** each of the heat-absorbing sheet (1a) and the heat-releasing sheet (1b) includes a sink (11) formed by etching, wherein each sink (11) has an annular wall (12) disposed therearound, wherein the annular wall (12) of the heat-absorbing sheet (1a) and the annular wall (12) of the heat-releasing sheet (1b) contact each other, and the two annular walls (12) are coupled by laser welding around contacted portions thereof.
